# EUROPEAN PATENT SPECIFICATION

(11) **EP 2 698 046 B1**
(45) Date of publication and mention of the grant of the patent: **21.06.2017**
(21) Application number: 12716811.0
(22) Date of filing: 20.03.2012
(51) Int. Cl.: H05K 5/00

(54) **COMBINED METAL COVER AND ANTI-CRUSH HOLE SUPPORT**
KOMBINATION AUS METALLABDECKUNG UND STÜTZFÜSSEN MIT QUETSCHSCHUTZÖFFNUNGEN
COUVERCLE MÉTALLIQUE ET SUPPORT À TROU ANTI-ÉCRASEMENT COMBINÉS

(30) Priority: 14.04.2011 US 201113086811
(43) Date of publication of application: 19.02.2014
(73) Proprietor: Continental Automotive Systems, Inc., Auburn Hills, MI 48326-1581 (US)
(72) Inventor: TETEAK, David, Crystal Lake, Illinois 60014 (US); BREY, Thomas, Lake in the Hills, Illinois 60156 (US)
(74) Representative: Bonn, Roman Klemens
(86) International application number: PCT/US2012/029750
(87) International publication number: WO 2012/141850

(56) References cited:
- DE-A1-102008 002 160
- US-A- 6 127 628
- US-A1- 2002 154 486
- US-B1- 6 420 652

## Description

### Background

Packaging for electronic products continues to move away from heavy and bulky metal enclosures for cost and weight-saving purposes. While plastic housings reduce cost and weight, plastic housings can be difficult to mount because plastics that are usable as housings are brittle and have relatively low elastic moduli. Mounting flanges or feet are easily crushed when the plastics they are made from are subjected to c compressive stress. Plastics are therefore somewhat ill-suited for use as housings or enclosures of electronic devices.

In US 2002/0154486 A1 an electronic control unit is disclosed which is mounted in a vehicle engine compartment. The electronic control unit comprises a plastic case body, metal collars each molded into the plastic case body, a metal base having bolt through-holes prepared in the same number of the metal collars, such that a bolt passes through each metal collar and one of the holes corresponding thereto. An outer surface of each metal collar that comes in contact with the plastic case body is formed with projections and depressions. Each metal collars is shaped to be protruded from the upper and lower ends of the plastic case body in the same direction as the bolt-through hole. The plastic case body and the metal base are joined together with adhesive in such a way that the metal collars and the metal base are fastened together with the bolts mounted in the engine compartment.

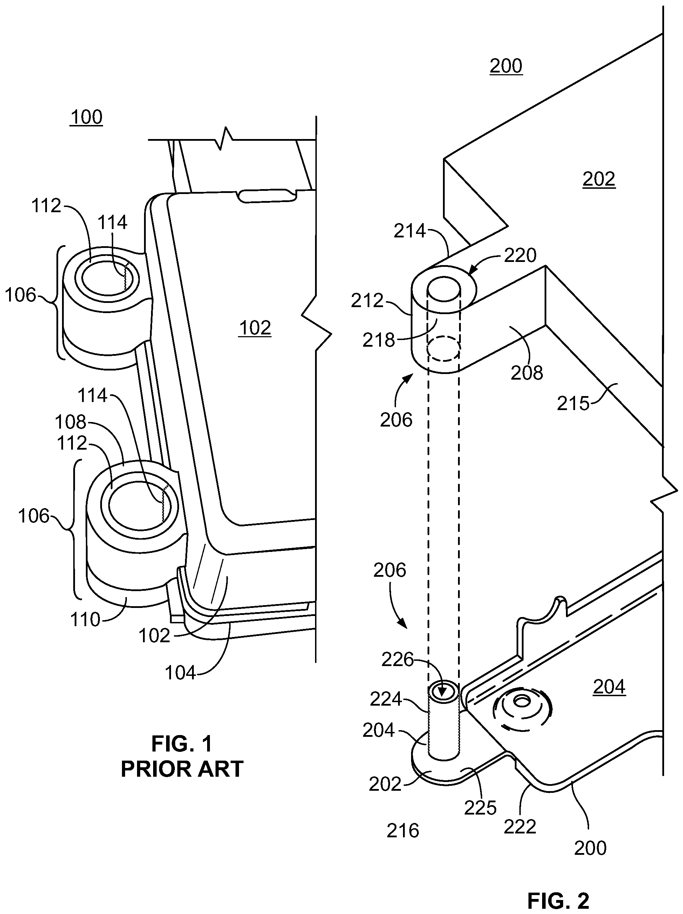

FIG. 1 is a perspective view of a prior art housing 100 for electronic devices. The housing 100 is comprised of a plastic top portion 102 and a metallic lower portion 104. Two mounting feet 106 are cantilevered, i.e., they project outwardly, from a side surface 107 of the housing 100. The mounting feet 106 are structures that enable the housing 100 to be attached to a surface.

Each mounting foot 106 is comprised of a plastic upper, generally cylindrically-shaped lug 108. The lug 108 has a hole or cylinder, which receives a separately-made and separately installed metallic insert support 112. The plastic lug 108 is attached to a second lug 110 that is metallic and which extends' laterally away from the side 109of a metallic lower portion 104 of the housing 100. The metal insert 112 extends from the top of the plastic lug 108 to the bottom of the second metal lug 110.

The metal insert 112 is installed into the foot 106 to provide a structure that can withstand compressive loads applied to the foot 106 by fasteners, which are not shown. Fasteners extend through the insert 112 and through an attachment surface to which the housing 100 is mounted. The insert 112 thus prevents the plastic lug 108 from being crushed.

### Brief Description of the Drawings

FIG. 1 is a perspective view of a prior art housing with mounting feet having separately inserted metal supports;
FIG. 2 is an exploded view of a combined metal cover and anti-crush hole inside a mounting foot;
FIG. 3A is bottom view of the structure depicted in FIG. 2 after assembly;
FIG. 3B is a top view of the structure shown in FIG. 2 after assembly;
FIG. 4 is an exploded view of a combined metal cover and anti-crush hole formed as part of a mounting foot;
FIG. 5 is cross sectional view of the structure shown in FIG. 4 after assembly;
FIG. 6 is a top view of an alternate embodiment of a metal cover and anti-crush hole, with the anti-crush hole located interior to a housing;
FIG. 7 and FIG. 8 are assembled and pre-assembled views of an alternate embodiment of a crush-resistant metal portion of a mounting foot;

### Detailed Description

Prior art metal inserts 112 that are inserted separately require manual insertion. They are also relatively expensive to manufacture because they are typically formed by rolling a flat metal tab into a cylinder as shown. Reference numeral 114 identifies a seam formed by rolling the insert 112. A housing having a combined metal cover and a crush-resistant or an anti-crush hole would be an improvement an improvement over the prior art.

It is well known that the degree to which structures deform in response to an applied stress depends on the material's modulus of elasticity. When stress and strain are proportional to each other, deformation of a material is considered to be elastic. When a material is stressed to its proportional limit, deformation is plastic, i.e., the material does not return to its original shape. Stated another way, a material fails, when it is subjected to a stress that exceeds its proportional limit or yield strength.

Plastics are generally less dense than metals. Plastics are also generally non-conductive. Another difference between plastics and metals is their elastic modulus. Plastics are not as strong as metals.

Plastics that include low density polyethylene or LDPE, high density polyethylene (HDPE), polypropylene (PP) and polyvinyl chloride (PVC) have a modulus of elasticity of about 0.025 x 10⁶ psi and about 5.0 x 10⁶ psi. Light weight aluminum alloys however have elastic moduli of about 10 x 10⁶ psi. Metals are therefore better able to withstand compressive loads.

FIG. 2 is an exploded view of a housing 200 comprised of a plastic top portion 202 and a metallic bottom portion 204. The plastic can be amorphous or polycrystalline. The housing 200 has crush-resistant or "anti-crush" supports 206 that extend from exterior sides of the housing 200.

The supports 206 are hereinafter referred to as mounting feet. A mounting foot is formed by the joinder or assembly of a top plastic portion 208 of the housing 200 and a metal bottom portion 210 of the housing 200. The metallic bottom portion 210 is formed to provide a metal, load-bearing insert, which when inserted into a plastic sleeve or cylinder resists crushing when a compressive stress is applied to the foot 206.

When viewed from the top, the foot 206 has a form reminiscent of a stilted arch. As used herein, "stilted arch" refers to an arch having a semi-circular rounded portion with straight legs or stilts that extend away from the ends of the semi-circular portion. In FIG. 2, the plastic top portion 208 of the mounting foot 206 has an arch-shaped portion identified by reference numeral 212. Plastic straight legs or stilts 214 extend laterally away from a side surface 215 of the plastic top portion 202 of the housing 200.

A cylindrical hole 218 is formed in the plastic top portion 208 of the foot 206. The circular-cross section hole 218 formed into the end of the foot 206 imbues the top portion 208 of the foot 206 with a structure that is cylindrical and formed from the plastic material surrounding the cylindrical hole 218. Reference numeral 220 identifies what is considered to be the outer circumference of a "cylinder" of material in the plastic top portion 208 of the foot 206. The plastic top portion 208 is thus considered to have a first cylindrical part 220 of the mounting foot 206.

The bottom portion 210 of the foot 206 is metallic. It therefore has an elastic modulus much greater than the plastic top portion 202.

The bottom portion 210 is comprised of a relatively thin, stilted arch-shaped tab portion 216 that extends laterally away from a side surface 222 of the metallic bottom portion 204.

The bottom portion 204 including the metal tab 216 is formed by stamping. A cylinder 224 extends upwardly from the tab 216 is also formed by a stamping process known as deep drawing. Being formed by stamping, the metal cylinder 224 is seamless. And, unlike prior art inserts that are stamped and rolled and therefore not really circular, the cross sectional shape of the stamped metallic cylinder 224 can be made into a nearly perfect circle.

In addition to being seamless and having nearly perfect circular cross sections, in one embodiment, the stamped metallic cylinder 224 has an outside diameter that tapers, or which has a "draft." The outside diameter at the top of the cylinder 224 is slightly less than the outside diameter of the cylinder 224 where it meets the tab 216. Providing a draft to the cylinder 224 facilitates assembly of the two pieces 202 and 204 to each other. In other embodiments, the cylinder 224 outside diameter is constant.

The bottom or lower end of the cylinder 224 is surrounded by a relatively flat or planar annulus 225, which meets the plastic "cylinder" 220 portion of the plastic top portion 202. The metallic cylinder 224 has a height that is substantially equal to or slightly greater than the thickness of the plastic first cylindrical part 220 of the plastic top portion 208.

By deep drawing the metal lower portion 204, it is possible to stamp a lower metal panel 204 having a metallic second cylinder 224, the outside diameter of which is just equal to the inside diameter of the hole 218 in the plastic upper portion of the foot 206. The metallic second cylinder 224 also has an inside diameter 226 selected to correspond to the outside diameter of a fastener used to attach the housing 200 to a surface. Fasteners are not shown in FIG. 2 for clarity. A complete housing 200 with a crush-resistant mounting foot 206 is formed when the plastic top portion 202 is joined with the bottom metallic portion 204.

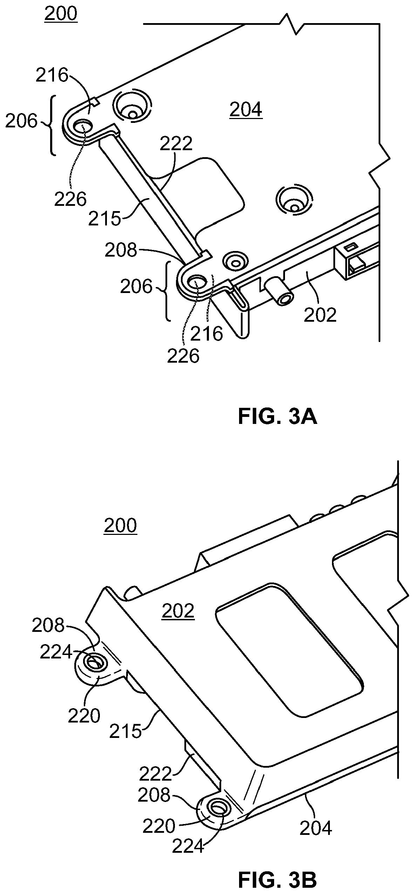

FIG. 3A is a bottom view of the housing 200 shown in FIG. 2. FIG. 3B is a top view of the housing 200.

Together, FIGS. 2, 3A and 3B show that the metallic cylinder 224 of the bottom portion 204 extends orthogonally from the tab 226 and extends completely through the thickness of the plastic top portion 208 of the foot 206. Unlike prior art metal inserts that are inserted manually and which have seams, the metallic cylinder 224 slides into the first plastic cylindrical part 220. The metallic cylinder 224, which extends through the first cylindrical part 220 and which has an elastic modulus greater than that of the plastic, significantly limits deformation of the first cylindrical portion responsive to a compressive load compressed on the foot 206 by a fastener. The metallic cylinder 224 thus provides the mounting foot 206 with an anti-crush hole.

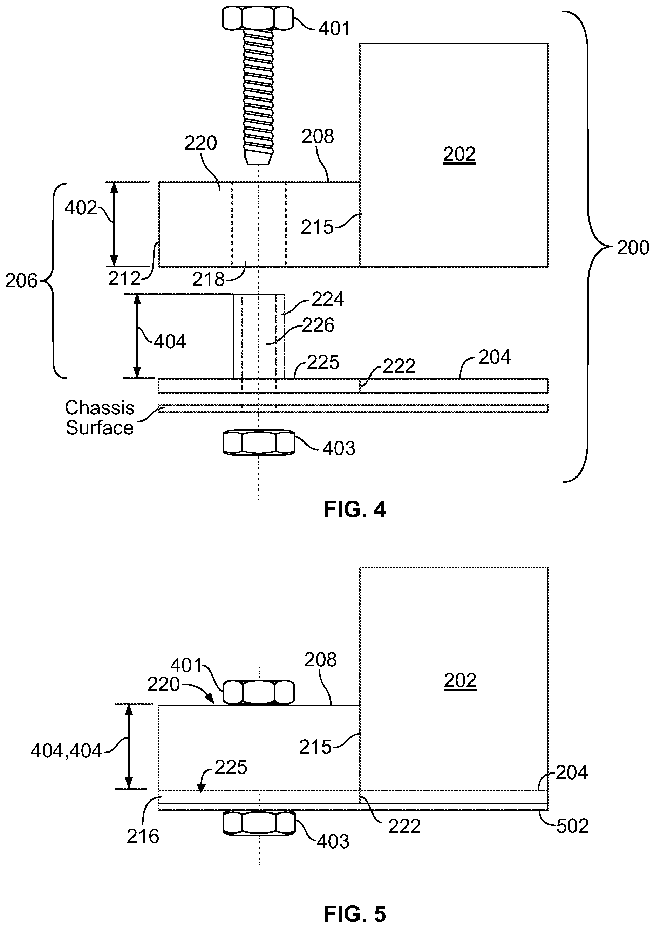

FIG. 4 is an exploded view of one mounting foot 206 that extends from sides of upper and lower portions of a housing 200 depicted in FIG. 2. FIG. 4 also shows a fastener, comprised of a bolt 401 and hex nut 403, positioned to fasten the two portions of the housing 200 together.

The thickness 402 of the plastic upper portion 208 of the foot 206 is shown to be substantially equal to the height 404 of the metallic second cylinder 224. Since the height 404 of the inner cylinder 224 is at least equal to and preferably slightly greater than the thickness 402 of the upper portion 208, insertion of the inner cylinder 224 into the cylindrical hole 218 provides a metallic structure inside a plastic structure with the metallic structure bearing load applied to the mounting foot 206 by a fastener 406. Tightening the hex nut 403 on the bolt 401 exerts compressive force on the metallic inner cylinder 224 but not on the plastic outer cylinder. In one embodiment, the thickness 402 is slightly less than the height 404 to enable the metallic second cylinder 224 to engage a compressive load before the plastic.

FIG. 5 is a cross sectional view of the assembled foot 206 depicted in FIG. 4. The bolt 401 and hex nut 403 are shown assembled to each other and attach the housing 200 to a surface 502, such as a surface of a metal chassis of an automobile or other vehicle. By inserting a metal cylinder into the plastic cylinder, compressive stress on the plastic cylinder is significantly reduced or even eliminated.

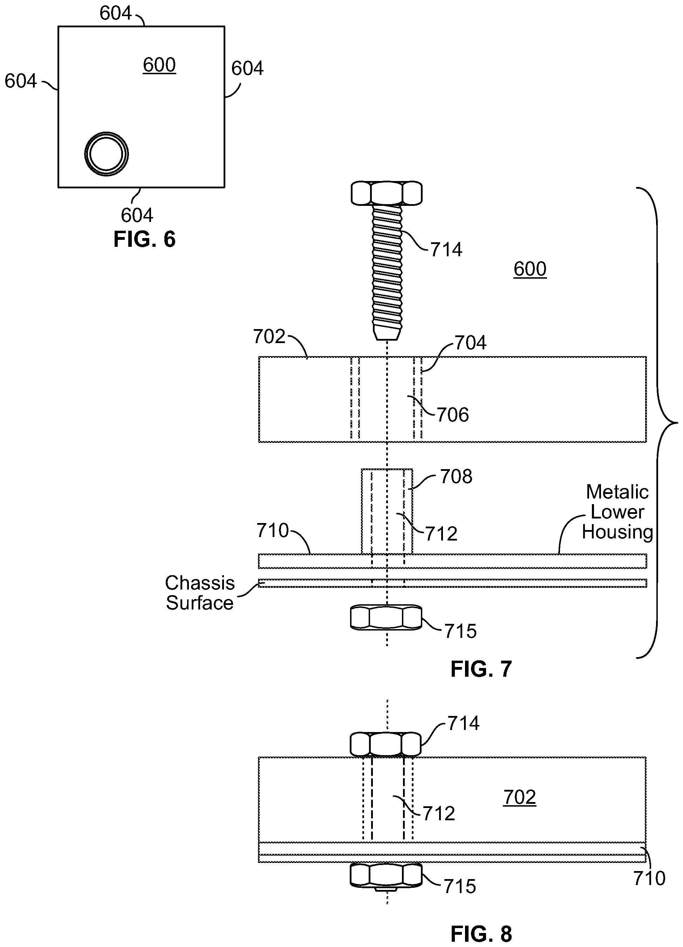

FIG. 6 is a top view of an alternate embodiment of a housing 600 formed from a plastic top portion and a metal bottom portion. Unlike the supports 206 described above and which extend outwardly from sidewalls of a housing, an anti-crush support 602 is located within the exterior side walls 604 the housing 600.

FIG. 7 is an exploded view of the housing 600 depicted in FIG. 6 and showing the structure of the interior-located support 602. A plastic outer cylinder 704 of the support 602 is formed through the plastic top portion 702 of the housing 600. The plastic outer cylinder 704 has an inside diameter 706 large enough to slide over, i.e., receive, a seamless and metallic inner cylinder 708 formed by stamping, and preferably deep drawing. The metallic cylinder 708 is stamped as part of a metallic plate from which a metallic bottom portion 710 of the housing 600 is formed. As with the embodiment described above, the metallic inner cylinder 708 can be formed with a slight draft or taper to facilitate assembly of the housing portions.

The metallic inner cylinder 708 has a central hole 712 large enough to receive a fastener, such as a bolt 714. When the plastic top portion 702 is joined to the metallic bottom portion 710, the metallic inner cylinder 708 extends all the way through the plastic outer cylinder 704 as described above with regard to the exterior foot 206.

FIG. 8 is a side view of the assembled housing 600 of FIG. 6. A bolt 714 is shown inserted into the hole 712 that exists in the metallic inner cylinder 708. The bolt 714 also extends through a thin, flat panel 800 to which the housing 600 is attached by tightening the hex nut 716 on the bolt 714.

When the fastener 712 and nut 714 are tightened, compressive stress is applied to the metallic inner cylinder 706. The plastic outer cylinder 704 is thus spared from force that might otherwise permanently deform, i.e., crush, the plastic top portion 702 of the housing 600.

In the embodiments described above and depicted in the figures, the cylinders have circular cross sections. Alternate and equivalent embodiments include "cylinders" that have non-circular cross sections, such as square, triangular and rectangular cross sections.

Those of ordinary skill in the art will recognize that a light-weight housing can be constructed with robust mounting supports by using supports formed from both plastic and metallic components. A metallic insert inside a plastic outer portion is able to withstand compressive loads greater than having a plastic portion.

The foregoing description is for purposes of illustration only. The true scope of the disclosure is set forth in the appurtenant claims.

## Claims

1. A housing (200; 600) having a plastic top portion (202, 208; 702) and a metal bottom portion (204) and at least a mounting foot (206; 602) for attaching the housing (200; 600) to a surface (502), the mounting foot (206; 602) being formed by assembly of the plastic top portion (202, 208; 702) and the metal bottom portion (204), wherein the mounting foot (206; 602) comprises:
a first cylindrical part (220; 704) comprising a cylindrical hole (218; 712) formed in the plastic top portion (202; 702); and
a second cylindrical part (224; 702) formed on the metal bottom portion (204) by stamping, the second cylindrical part (224; 702) extending inside the first cylindrical part (220; 704) when the plastic top portion (202, 208; 702) is joined with the metal bottom portion (204) and configured to limit deformation of the first cylindrical part (220; 704) responsive to a compressive load impressed on the mounting foot (206; 602).

2. The housing of claim 1, wherein the plastic top portion (202, 208; 702) of the housing (200; 600) and the first cylindrical part (220) are comprised of a plastic having a first modulus of elasticity and wherein the metal bottom portion (204) of the housing (200; 600) and the second cylindrical part (224) are metallic having a second modulus of elasticity greater than the first modulus of elasticity.

3. The housing of claim 1, wherein the first cylindrical part (220) is cantilevered from a surface of the plastic top portion (202, 208; 702) and wherein the second cylindrical part (224; 702) is cantilevered from a surface of the metal bottom portion (204).

4. The housing of claim 1, wherein the second cylindrical part (224; 702) is seamless and/or tapered.

5. The housing of claim 1, wherein the second cylindrical part (224; 702) has a substantially perfect circular cross section.

6. The housing of claim 1, wherein the first cylindrical part (220) has a first length (402) and a first inside diameter and wherein the second cylindrical part (224; 702) has second length (404) at least as long as the first length (402) and an outside diameter less than the first inside diameter, whereby compressive load on the mounting foot (206; 602) is applied to and supported by the second cylindrical part (224) prior to deformation of the first cylindrical part (220).

7. The housing of claim 6, wherein the second cylindrical part (224) is additionally comprised of an annular foundation, proximate one end of the second cylindrical part (224), extending around the outside of the second cylindrical part (224) and supporting the first cylindrical part (220).

8. The housing of claim 1, wherein the second cylindrical part (204) is a cylinder (224) which is configured to align the plastic top portion (202, 208; 702) and the metal bottom portion (204) of the housing (200, 600) to each other.

9. The housing of claim 1, further comprised of a fastener (401) extending through the mounting foot (602) and applying a compressive load thereto.

10. The housing of claim 1, wherein the metal bottom portion (204) is substantially planar.

11. The housing of claim 1, wherein the first and second cylindrical parts (220, 224) being cantilevered from side surfaces of the plastic top portion (202, 208; 702) and the metal bottom portion (204) respectively, wherein the second cylindrical part (224) extends orthogonally from a tab (216) that extends away from the side surface of the metal bottom portion (204). and

12. The housing of claim 9, wherein the second cylindrical part (224) having an inside diameter (226) selected to receive the fastener (401)to attach the housing (200).

13. The housing of claim 1, wherein the second cylindrical part (224) is a material having a modulus of elasticity selected to prevent the first cylindrical part (220) from being deformed upon the application of a compressive load to the support.

14. The housing of claim 9 or 12, wherein the compressive load is applied by the fastener (401).

15. The housing of claim 1, wherein the bottom portion (204) is formed by stamping.

## Patentansprüche

1. Gehäuse (200; 600) mit einem Kunststoffoberteil (202, 208; 702) und einem Metallunterteil (204) und wenigstens einem Montagefuß (206; 602) zum Anbringen des Gehäuses (200; 600) an einer Oberfläche (502), wobei der Montagefuß (206; 602) durch einen Zusammenbau des Kunststoffoberteils (202, 208; 702) und des Metallunterteils (204) gebildet wird, wobei der Montagefuß (206; 602) Folgendes aufweist:
einen ersten zylindrischen Teil (220; 704), der ein zylindrisches Loch (218; 712) aufweist und der in dem Kunststoffoberteil (202; 702) gebildet ist; und
einen zweiten zylindrischen Teil (224; 702), der durch Formstanzen auf dem Metallunterteil (204) gebildet ist, wobei sich der zweite zylindrische Teil (224; 702) innerhalb des ersten zylindrischen Teils (220; 704) erstreckt, wenn der Kunststoffoberteil (202, 208; 702) mit dem Metallunterteil (204) verbunden ist, und der dazu ausgebildet ist, eine Verformung des ersten zylindrischen Teils (220; 704), der auf eine Druckbelastung auf den Montagefuß (206; 602) reagiert, zu begrenzen.

2. Gehäuse nach Anspruch 1, wobei der Kunststoffoberteil (202, 208; 702) des Gehäuses (200; 600) und der erste zylindrische Teil (220) aus einem Kunststoff mit einem ersten Elastizitätsmodul bestehen und wobei der Metallunterteil (204) des Gehäuses (200; 600) und der zweite zylindrische Teil (224) metallisch mit einem zweiten Elastizitätsmodul, der größer als der erste Elastizitätsmodul ist, sind.

3. Gehäuse nach Anspruch 1, wobei der erste zylindrische Teil (220) von einer Oberfläche des Kunststoffoberteils (202, 208; 702) ausgekragt ist und wobei der zweite zylindrische Teil (224; 702) von einer Oberfläche des Metallunterteils (204) ausgekragt ist.

4. Gehäuse nach Anspruch 1, wobei der zweite zylindrische Teil (224; 702) nahtlos und/oder konisch ist.

5. Gehäuse nach Anspruch 1, wobei der zweite zylindrische Teil (224; 702) einen im Wesentlichen perfekt kreisförmigen Querschnitt aufweist.

6. Gehäuse nach Anspruch 1, wobei der erste zylindrische Teil (220) eine erste Länge (402) und einen ersten Innendurchmesser aufweist und wobei der zweite zylindrische Teil (224; 702) eine zweite Länge (404), die wenigstens so lang wie die erste Länge (402) ist, und einen Außendurchmesser, der geringer als der erste Innendurchmesser ist, aufweist, wobei eine Druckbelastung auf den Montagefuß (206; 602) vor der Verformung des ersten zylindrischen Teils (220) auf den zweiten zylindrischen Teil (224) ausgeübt und durch diesen getragen wird.

7. Gehäuse nach Anspruch 6, wobei der zweite zylindrische Teil (224) zusätzlich aus einer ringförmigen Basis besteht, die nahe einem Ende des zweiten zylindrischen Teils (224) ist, sich um die Außenseite des zweiten zylindrischen Teils (224) erstreckt und den ersten zylindrischen Teil (220) stützt.

8. Gehäuse nach Anspruch 1, wobei der zweite zylindrische Teil (204) ein Zylinder (224) ist, der dazu konfiguriert ist, den Kunststoffoberteil (202, 208; 702) und den Metallunterteil (204) des Gehäuses (200, 600) miteinander auszurichten.

9. Gehäuse nach Anspruch 1, das ferner aus einem Befestigungselement (401) besteht, das sich durch den Montagefuß (602) erstreckt und eine Druckbelastung auf diesen ausübt.

10. Gehäuse nach Anspruch 1, wobei der Metallunterteil (204) im Wesentlichen ebenflächig ist.

11. Gehäuse nach Anspruch 1, wobei der erste und zweite zylindrische Teil (220, 224) jeweils von Seitenoberflächen des Kunststoffoberteils (202, 208; 702) bzw. dem Metallunterteil (204) ausgekragt sind, wobei sich der zweite zylindrische Teil (224) orthogonal von einem Streifen (216) erstreckt, der sich von der Seitenoberfläche des Metallunterteils (204) weg erstreckt.

12. Gehäuse nach Anspruch 9, wobei der zweite zylindrische Teil (224) einen Innendurchmesser (226) aufweist, der zum Aufnehmen des Befestigungselements (401) gewählt ist, um das Gehäuse (200) anzubringen.

13. Gehäuse nach Anspruch 1, wobei der zweite zylindrische Teil (224) ein Material mit einem Elastizitätsmodul ist, der gewählt ist, um zu verhindern, dass der erste zylindrische Teil (220) bei der Ausübung einer Druckbelastung auf die Stütze verformt wird.

14. Gehäuse nach Anspruch 9 oder 12, wobei die Druckbelastung durch das Befestigungselement (401) ausgeübt wird.

15. Gehäuse nach Anspruch 1, wobei der Unterteil (204) durch Formstanzen gebildet ist.

## Revendications

1. Boîtier (200 ; 600) possédant une portion supérieure en plastique (202, 208 ; 702) et une portion inférieure en métal (204) et au moins un pied de montage (206 ; 602) pour fixer le boîtier (200 ; 600) à une surface (502), le pied de montage (206 ; 602) étant formé par assemblage de la portion supérieure en plastique (202, 208 ; 702) et de la portion inférieure en métal (204), dans lequel le pied de montage (206 ; 602) comprend :
une première partie cylindrique (220 ; 704) comprenant un trou cylindrique (218 ; 712) formé dans la portion supérieure en plastique (202 ; 702) ; et
une seconde partie cylindrique (224 ; 702) formée sur la portion inférieure en métal (204) par estampage, la seconde partie cylindrique (224 ; 702) s'étendant à l'intérieur de la première partie cylindrique (220 ; 704) lorsque la portion supérieure en plastique (202, 208 ; 702) est jointe à la portion inférieure en métal (204) et étant configurée pour limiter la déformation de la première partie cylindrique (220 ; 704) en réponse à une charge de compression imprimée sur le pied de montage (206 ; 602).

2. Boîtier selon la revendication 1, dans lequel la portion supérieure en plastique (202, 208 ; 702) du boîtier (200 ; 600) et la première partie cylindrique (220) sont composées d'un plastique possédant un premier module d'élasticité et dans lequel la portion inférieure en métal (204) du boîtier (200 ; 600) et la seconde partie cylindrique (224) sont métalliques, possédant un second module d'élasticité supérieur au premier module d'élasticité.

3. Boîtier selon la revendication 1, dans lequel la première partie cylindrique (220) est en porte-à-faux à partir d'une surface de la portion supérieure en plastique (202, 208 ; 702) et dans lequel la seconde partie cylindrique (224 ; 702) est en porte-à-faux à partir d'une surface de la portion inférieure en métal (204).

4. Boîtier selon la revendication 1, dans lequel la seconde partie cylindrique (224 ; 702) est sans soudure et/ou effilée.

5. Boîtier selon la revendication 1, dans lequel la seconde partie cylindrique (224 ; 702) présente une section transversale circulaire sensiblement parfaite.

6. Boîtier selon la revendication 1, dans lequel la première partie cylindrique (220) possède une première longueur (402) et un premier diamètre intérieur et dans lequel la seconde partie cylindrique (224 ; 702) possède une seconde longueur (404) au moins aussi longue que la première longueur (402) et un diamètre extérieur inférieur au premier diamètre intérieur, moyennant quoi la charge de compression sur le pied de montage (206 ; 602) est appliquée sur et supportée par la seconde partie cylindrique (224) avant la déformation de la première partie cylindrique (220).

7. Boîtier selon la revendication 6, dans lequel la seconde partie cylindrique (224) est en outre composée d'une base annulaire, à proximité d'une extrémité de la seconde partie cylindrique (224), s'étendant autour de l'extérieur de la seconde partie cylindrique (224) et supportant la première partie cylindrique (220).

8. Boîtier selon la revendication 1, dans lequel la seconde partie cylindrique (204) est un cylindre (224) qui est configuré pour aligner la portion supérieure en plastique (202, 208 ; 702) et la portion inférieure en métal (204) du boîtier (200, 600) l'une sur l'autre.

9. Boîtier selon la revendication 1, composé en outre d'un élément de fixation (401) s'étendant à travers le pied de montage (602) et appliquant une charge de compression sur celui-ci.

10. Boîtier selon la revendication 1, dans lequel la portion inférieure en métal (204) est sensiblement plane.

11. Boîtier selon la revendication 1, dans lequel les première et seconde parties cylindriques (220, 224) sont en porte-à-faux à partir de surfaces latérales de la portion supérieure en plastique (202, 208 ; 702) et de la portion inférieure en métal (204) respectivement, dans lequel la seconde partie cylindrique (224) s'étend orthogonalement à partir d'une languette (216) qui s'étend dans une direction s'éloignant de la surface latérale de la portion inférieure en métal (204).

12. Boîtier selon la revendication 9, dans lequel la seconde partie cylindrique (224) possède un diamètre intérieur (226) sélectionné pour recevoir l'élément de fixation (401) pour fixer le boîtier (200).

13. Boîtier selon la revendication 1, dans lequel la seconde partie cylindrique (224) est un matériau possédant un module d'élasticité sélectionné pour empêcher la première partie cylindrique (220) d'être déformée lors de l'application d'une charge de compression sur le support.

14. Boîtier selon la revendication 9 ou 12, dans lequel la charge de compression est appliquée par l'élément de fixation (401).

15. Boîtier selon la revendication 1, dans lequel la portion inférieure (204) est formée par estampage.
